# FASCICULE DE BREVET EUROPEEN

(11) **EP 0 965 994 B1**
(45) Date de publication et mention de la délivrance du brevet: **26.01.2005**
(21) Numéro de dépôt: 99401472.8
(22) Date de dépôt: 15.06.1999
(51) Int. Cl.: G11C 16/06, G11C 7/00, G06F 12/14

(54) **Dispositif à circuit intégré sécurisé au moyen de lignes complémentaires de bus**
Mit Hilfe komplementärer Busleitungen gesicherte integrierte Schaltkreisanordnung
Integrated circuit device secured by complementary bus lines

(30) Priorité: 15.06.1998 FR 9807530
(43) Date de publication de la demande: 22.12.1999
(73) Titulaire: Axalto S.A., 92120 Montrouge (FR)
(72) Inventeur: Leydier, Robert, 91400 Orsay (FR)

(56) Documents cités:
- EP-A- 0 279 712
- EP-A- 0 298 848
- EP-A- 0 330 852
- US-A- 4 980 856
- PARET D: "MICROCONTROLEURS ET PROTECTION DE CODE" ELECTRONIQUE RADIO PLANS, no. 527, 1 octobre 1991 (1991-10-01), pages 69-74, XP000265630

## Description

L'invention concerne des dispositifs à circuit intégré destinés à être incorporés dans des objets portatifs et, en particulier, dans des objets portatifs au format carte appelés cartes à puce.

Les cartes à puce sont en général utilisées dans des applications dans lesquelles la sécurité du stockage et du traitement d'informations confidentielles sont essentielles. Ces cartes sont par exemple destinées à des applications du domaine de la santé, à des applications de la télévision à péage, ou encore, à des applications dites de porte-monnaie électronique.

Elles se composent d'un corps de carte plastique dans lequel est incorporé un dispositif à circuit intégré. Il s'agit d'un module électronique comportant une puce à circuit intégré ou de la puce à circuit intégré elle-même.

Une puce à circuit intégré comporte de manière classique une unité centrale de traitement (CPU) qui gère et distribue, par l'intermédiaire de lignes de bus, des données ou des adresses d'informations notamment stockées dans des mémoires volatiles ou non de ladite puce.

Les portes logiques constitutives du circuit intégré sont réalisées en technologie C MOS. Elles sont constituées de transistors P MOS et N MOS. Ces portes consomment du courant lorsque les transistors passent d'un état passant à un état non-passant ou réciproquement. Par ailleurs, des connexions entre ces portes, notamment les lignes de bus, forment des capacités électriques qui consomment elles-mêmes, durant leur mise en charge, des courants électriques. C'est le cas notamment lorsque lesdites lignes de bus sont amenées à transporter l'information logique 1.

Aussi, l'intensité du courant consommé par un dispositif à circuit intégré en fonction du temps varie selon les tâches accomplies par ledit dispositif.

Le suivi de cette intensité en fonction du temps constitue donc une signature électrique de l'activité du dispositif à circuit intégré et l'analyse de cette signature électrique et, plus exactement, de son amplitude en fonction du temps, est révélatrice de ladite activité. Elle permet aux fraudeurs d'accéder à des informations confidentielles, par exemple des clés secrètes, transportées le long des lignes de bus et contenues dans les mémoires du circuit intégré ou encore de suivre le déroulement d'instructions et d'attaquer les secrets par analyse des temps caractéristiques du courant consommé par le circuit intégré au cours d'une transaction.

En vue d'éviter de telles analyses de signatures, certains procédés de l'état de la technique proposent d'utiliser des algorithmes qui permettent le déclenchement d'opérations à des moments pseudoaléatoires. D'autres procédés proposent de générer des courants d'alimentation bruités riches en informations aléatoires, ou encore, en opérations erronées.

Les procédés précités de l'état de la technique comportent de multiples inconvénients. En particulier, ils monopolisent certaines ressources du dispositif, qui pourraient être utilisées dans la réalisation d'autres opérations. De plus, ces procédés ne sont pas sûrs. En effet, les techniques d'analyse du courant de séquences stimulées par des commandes particulières sont très efficaces. Elles permettent d'obtenir finalement les informations confidentielles recherchées.

Par ailleurs, un autre procédé encore de l'état de la technique, non encore rendu accessible au public au jour de dépôt de la présente demande de brevet, et qui fait l'objet de la demande enregistrée en France le 4 février 1998 sous le numéro 98.01305 (= WO-A-9 940 538), permet d'atténuer les signatures électriques au moyen d'une capacité notamment d'une valeur supérieure à 0,1 nanofarad.

Considérant ce qui précède, un problème technique posé est : de sécuriser les opérations et les accès aux données confidentielles en rendant l'analyse des signatures électriques de dispositifs à circuit intégré plus complexe au moyen de techniques autres que celle présentée dans la demande précitée et enregistrée sous le numéro 98.01305.

Un dispositif à circuit intégré comme décrit dans le préambule de la revendication 1 est connu du document US-A- 4 980 860.

Une solution à ce problème, telle que proposée selon l'invention, a pour objet un dispositif à circuit intégré destiné à être incorporé dans un objet portatif à mémoire, notamment au format carte, comportant au moins :
une unité centrale de traitement ;
au moins une mémoire ;
au moins un plot d'entrée/sortie de données ;
n lignes de bus d'adresses reliant l'unité centrale de traitement à la mémoire et/ou au plot d'entrée/sortie pour une transmission de bits d'adresses ; et
p lignes de bus de données reliant l'unité centrale à la mémoire et/ou au plot d'entrée/sortie pour une transmission de bits de données,
caractérisé en ce qu'au moins une ligne de bus d'adresses ou de données est complétée d'une ligne complémentaire destinée à une transmission de bits complémentaires aux bits transmis dans ladite ligne de bus d'adresses ou de données.

Ainsi, le transfert du couple d'informations, par exemple 1 sur une ligne de bus de données ou d'adresse et 0 sur la ligne complémentaire, draine la même quantité de courant que le ferait le transfert du couple d'information, 0 sur la même ligne de bus de données ou d'adresses et 1 sur la même ligne complémentaire. La consommation du courant est de ce fait toujours la même et l'analyse de la signature électrique du dispositif en fonctionnement ne permet pas de déterminer la nature des bits transportés le long de la ligne de bus.

L'invention sera mieux comprise à la lecture de l'exposé non limitatif qui suit, rédigé au regard des dessins qui l'accompagnent, dans lesquels :
la figure 1 montre, en vue de face, un module électronique muni d'une puce à circuit intégré dont les plages de contact affleurent à la surface d'un corps de carte ;
la figure 2 montre, en vue de face, une puce à circuit intégré et ses plots de connexion ;
la figure 3 montre, de manière schématique, les différents éléments fonctionnels constitutifs d'un circuit intégré réalisé selon l'invention ;
la figure 4 montre, en coupe transversale, une ligne de bus déposée sur un substrat silicium d'une puce à circuit intégré ;
la figure 5 est un schéma électrique des connexions des lignes de bus et des lignes complémentaires aux mémoires ROM et EEPROM ; et
la figure 6 représente les courants consommés par la commande d'une ligne de bus, sa ligne complémentaire et l'ensemble constitué desdites lignes.

Le présent exposé de l'invention a trait à l'exemple des cartes à puce. Néanmoins, il est bien entendu que l'invention s'applique de manière générale à tout dispositif à circuit intégré destiné à être incorporé dans un objet portatif à mémoire tel qu'un module d'identification abonné (SIM) au format jeton ou une étiquette électronique.

Les cartes à puce sont des objets portables standards fonctionnant avec et/ ou sans contact et qui sont définis notamment dans les normes ISO 78-10, 78-16 et 14443.

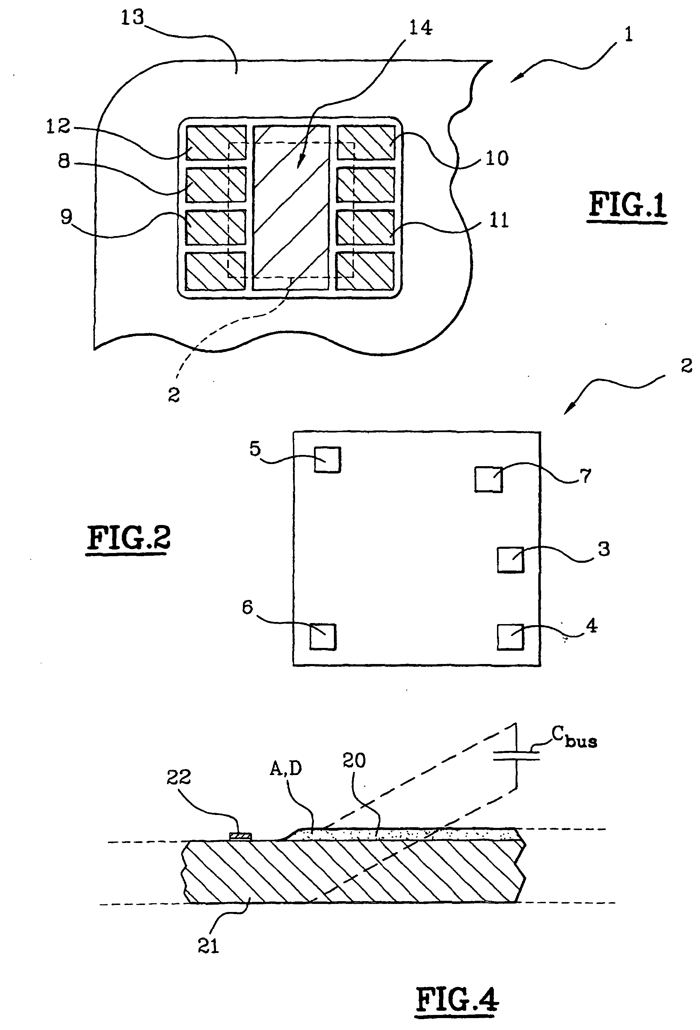

Ainsi que cela est plus particulièrement montré aux figures 1 et 2, les cartes 1, qui présentent un mode de fonctionnement à contacts, comprennent une puce 2 à circuit intégré dont cinq plots de contact au moins 3, 4, 5, 6 et 7 sont connectés électriquement, par des fils conducteurs non représentés, à, respectivement, cinq plages de contact 8, 9, 10, 11 et 12 affleurant à la surface d'un corps 13 de carte. Le plot de contact Reset 3 est connecté à une plage de contact Reset 8, le plot de contact Clock 4 est connecté à la plage de contact Clock 9, le plot de contact Vss 5 est connecté à la plage de contact Vss 10, le plot de contact d'entrée/sortie I/O 6 est connecté à la plage de contact I/O 11 et le plot de contact Idd 7 est connecté à la plage de contact Vdd 12.

L'ensemble, puce 2, fils conducteurs et plages de contact 8, 9, 10, 11 et 12 est en général compris dans un module électronique 14 incorporé dans le corps 13 de carte.

Le dispositif à circuit intégré selon l'invention est notamment le module électronique 14 portant les plages 8, 9, 10, 11 et 12 et comportant la puce 2, ou alors, la puce 2 elle-même.

Le circuit intégré du dispositif selon l'invention comprend différentes unités fonctionnelles. Il s'agit notamment d'une unité centrale de traitement CPU et de mémoires volatiles RAM ou non volatiles ROM, EEPROM. Il peut s'agir par ailleurs d'autres unités voire de sous-unités desdites unités, par exemple d'un crypto-processeur plus particulièrement destiné au codage cryptographique de données nécessitant des structures de calculs spécialisées.

En outre, le circuit intégré comporte un bus d'adresse BA et un bus de données BD.

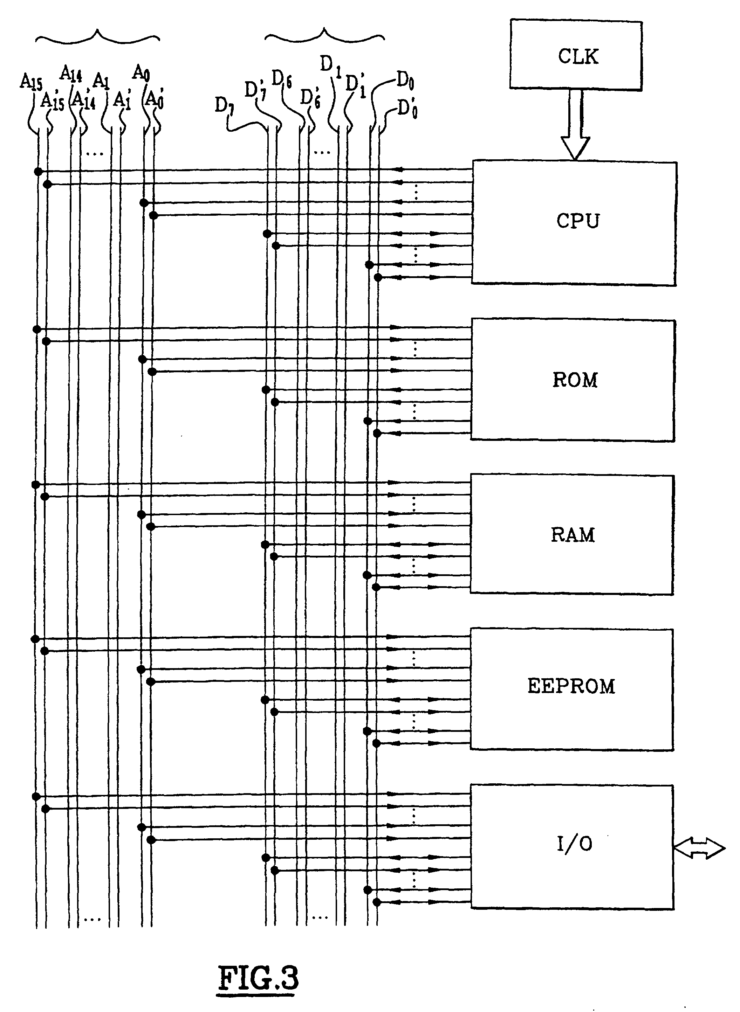

Le bus d'adresses AB se compose de n lignes de bus d'adresses reliant la CPU aux mémoires RAM, ROM, EEPROM et au plot I/O, n étant un nombre entier supérieur ou égal à 1. A la figure 3, n est égal à 16 et les 16 lignes de bus sont référencées A₀, A₁, ..., A₁₅.

Le bus de données BD se compose de p lignes de bus de données reliant la CPU aux mémoires RAM, ROM, EEPROM et au plot I/O, p étant un nombre entier supérieur ou égal à 1. A la figure 3, P est égal à 8 et les 8 lignes de bus sont référencées D₀, D₁, ..., D₇.

Chaque ligne de bus d'adresses A₀, A₁, ..., A₁₅ est susceptible de transporter une valeur logique 0 ou 1 d'un bit de poids déterminé d'une adresse codée sur 16 bits. Ce transport s'effectue de manière unidirectionnelle, de la CPU vers, selon les cas, les mémoires RAM, ROM, EEPROM ou le plot I/O.

Chaque ligne de bus de données D₀, D₁, ..., D₇ est susceptible de transporter une valeur logique 0 ou 1 d'un bit de poids déterminé d'une donnée codée sur 8 bits. Ce transport s'effectue, selon le cas, de manière unidirectionnelle, ou alors, de manière bidirectionnelle. Les sens possibles de transport sont indiqués par des flèches à la figure 3.

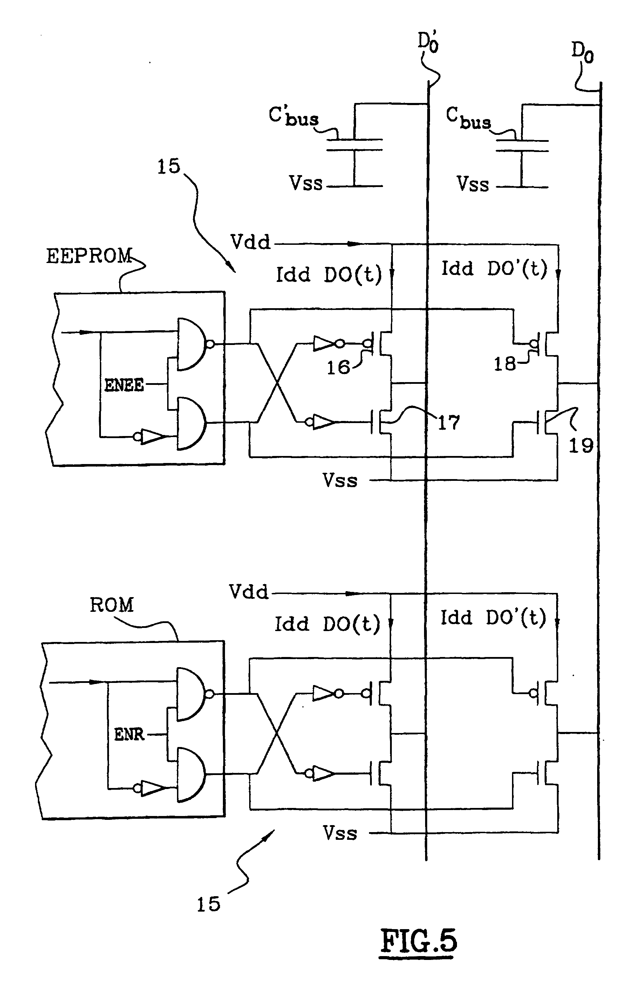

Ainsi que cela est montré à la figure 4, les lignes de bus d'adresses A₀, A₁, ..., A₁₅ et de données D₀, D₁, ..., D₇ sont des lignes conductrices constituées d'une épaisseur métallisée A, D déposée sur une couche d'oxyde de silicium épais 20 elle-même déposée sur un substrat silicium 21 de la puce 2. L'épaisseur d'une ligne A, D est en pratique de l'ordre du micron, par exemple de 0,7 µm. La largeur d'une ligne est de même très faible, en pratique de l'ordre de 2 µm. La longueur d'une ligne peut être importante, jusqu'à 8 mm. Dans ce cas, la surface d'une ligne de bus est de l'ordre de 2 x 8.000 = 16.000 µm².

La figure 4 montre par ailleurs le transistor de commande 22 de la ligne.

Selon l'invention, au moins une ligne de bus d'adresses A₀, A₁, ... ou A₁₅ ou une ligne de bus de donnée D₀, D₁, ..., D₇ est complétée d'une ligne complémentaire de bus.

Dans le mode de réalisation préféré de l'invention présenté à la figure 3, les 16 lignes de bus d'adresses A₀, A₁, ..., A₁₅ et les 8 lignes de bus de données D₀, D₁, ..., D₇ sont complétées par 16 lignes complémentaires A'₀, A'₁, ..., A'₁₅ et 8 lignes complémentaires D'₀, D'₁, ..., D'₇.

Dans un exemple, chaque ligne complémentaire de bus est, de même que la ligne de bus qu'elle complète, constituée d'une épaisseur métallisée déposée sur l'oxyde épais 20 du substrat silicium 21 de la puce, immédiatement à côté de la ligne qu'elle complète et en suit donc le parcours à la face active du circuit. Aussi, chaque ligne complémentaire de bus a une surface équivalente à la ligne de bus d'adresses ou de données qu'elle complète.

Dans d'autres exemples, les lignes complémentaires ne suivent pas le parcours des lignes de bus qu'elles complètent mais ont alors avantageusement une capacité C'_{bus} voisine de la capacité C_{bus} desdites lignes de bus.

Ainsi que cela est montré à la figure 5, les lignes de bus d'adresses A₀, A₁, ..., A₁₅ et de données D₀, D₁, ..., D₇ sont, de même que les lignes complémentaires de bus A'₀, A'₁, ..., A'₁₅ et D'₀, D'₁, ..., D'₇, connectées électriquement aux unités fonctionnelles auxquelles elles sont rattachées par des amplificateurs dits trois états doublés 15. Ces amplificateurs trois états doublés 15 constituent des portes de commande des liaisons des lignes auxquelles sont rattachées les unités fonctionnelles, par exemple ROM et EEPROM.

Un amplificateur trois états doublé 15 selon l'invention comprend un premier transistor P MOS 16 connecté en série avec un premier transistor N MOS 17 ainsi qu'un second transistor P MOS 18 connecté en série avec un second transistor N MOS 19. Toutefois, le premier transistor P MOS 16 est connecté au second transistor N MOS 19 et le premier transistor N MOS 17 est connecté au second transistor P MOS 18 de manière que, d'une part, le premier transistor P MOS 16 et le second transistor N MOS 19 et, d'autre part, le premier transistor N MOS 17 et le second transistor P MOS 18, soient commandés par des mêmes signaux de commande.

A la figure 5, on a représenté des signaux ENR et ENEE qui commandent, respectivement, les accès aux lignes de bus connectées à la mémoire ROM et à la mémoire EEPROM. Ces signaux sont actifs exclusivement. Ainsi, lorsque le signal de commande ENR est actif, seuls les amplificateurs trois états doublés de la ROM sont susceptibles d'imposer leurs signaux logiques 0 ou 1 aux lignes de bus ou aux lignes complémentaires de bus à laquelle ladite ROM est connectée. Dans ce cas, l'amplificateur trois états doublé 15 connecté à la mémoire EEPROM est en mode haute impédance. Aucun des transistors de cet amplificateur n'est conducteur. Réciproquement, lorsque le signal de commande ENEE est actif, seuls les amplificateurs trois états doublés de l'EEPROM sont susceptibles d'imposer leurs signaux logiques 0 ou 1 aux lignes de bus ou aux lignes complémentaires de bus auxquelles ladite EEPROM est connectée. Dans ce cas, l'amplificateur trois états 15 connecté à la mémoire ROM est en mode haute impédance. Aucun des transistors de cet amplificateur n'est conducteur.

Par exemple, lorsque le signal ENR est actif et que le signal issu de la mémoire ROM est au niveau logique 1, le premier transistor P MOS 16 force la tension sur le bus de donnée D₀ au niveau logique 1 mais force néanmoins la tension sur le second transistor N MOS 19 au niveau logique 0. Ainsi, un bit de données 1 est transmis à la ligne D₀ et un bit de données 0, complémentaire au bit de données 1 précité, est transmis à la ligne D'₀, au même moment.

Le mécanisme expliqué ci-dessus est, non seulement mis en oeuvre sur l'ensemble des lignes de bus de données D₀, D₁, ..., D₇ associées aux lignes complémentaires D'₀, D'₁, ..., D'₇, mais aussi, sur l'ensemble des lignes de bus d'adresses A₀, A₁, ..., A₁₅ associées aux lignes complémentaires A'₀, A'₁, ..., A'₁₅.

Ainsi, pour toute donnée ou adresse logique transmise respectivement par le bus BD ou le bus BA, une donnée ou adresse logique complémentaire est transmise simultanément par le bus complémentaire. Soit a le nombre de bits à 1 pour le bus de données. Soit b le nombre de bits à 0 pour le bus de données complémentaire. Pour un microcontrôleur 8 bits, le bus de données possède 8 bits. Ainsi, le nombre de bits à 1 pour l'ensemble des bus de données est tel que a + b = 8. Soit c le nombre de bits à 1 pour le bus d'adresses. Soit d le nombre de bits à 1 pour le bus d'adresses complémentaire. Pour un microcontrôleur capable d'adresser 65536 octets, le bus d'adresses possède 16 bits. Ainsi, le nombre de bits à 1 pour l'ensemble des bus d'adresses est tel que c + d = 16.

A titre d'exemple, considérons une instruction ayant pour code binaire 1 0 0 1 1 1 0 1 et pour code hexadécimal, 9D. Chacun des 8 bits est transmis simultanément, selon son poids, sur une ligne de bus de données D₀, D₁, D₂, D₃, D₄, D₅, D₆ ou D₇ et le nombre logique complémentaire, constitué des 8 bits 0 1 1 0 0 0 1 0, est de même transmis simultanément sur les lignes complémentaires D'₀, D'₁, D'₂, D'₃, D'₄, D'₅, D'₆ et D'₇. L'addition des bits à 1 constitutifs du mot logique 1 0 0 1 1 1 0 1 et de ceux constitutifs de son complémentaire 0 1 1 0 0 0 1 0 est égale à 8.

Un avantage du dispositif selon l'invention va maintenant être détaillé ci-après.

Dans un dispositif à circuit intégré selon l'état de la technique ou selon l'invention, la surface des lignes de bus intégrées à la face active de la puce 2 est, nous l'avons vu précédemment (figure 4), susceptible d'atteindre 16.000 µm². Ces lignes constituent la première électrode d'une capacité parasite C_{bus}, la deuxième électrode étant le substrat 21 du circuit intégré et son diélectrique, l'oxyde de silicium 20 déposé à la face active de la puce 2. La capacité parasite C_{bus} associée à chaque ligne de bus est de l'ordre du picofarad et, chaque fois qu'un bit 1 est transporté par une ligne de bus, cette capacité C_{bus} consomme, en se chargeant, une puissance électrique. Cette puissance électrique consommée est à l'origine de variations de l'intensité du courant consommé par le circuit intégré en fonction du temps Idd(t) et l'analyse de ce courant constitue une signature électrique révélatrice de son activité.

Dans un dispositif selon l'état de la technique, l'analyse des signatures électriques permet d'accéder aux informations, données ou adresses, transportées par les lignes de bus puisque Idd(t) est fonction des bits transportés.

Par contre, dans un dispositif à circuit intégré selon l'invention, le courant consommé Idd(t) est indépendant des données ou des adresses transportées sur les lignes de bus. En effet, ce courant Idd(t) est constitué de l'addition des courants consommés dans les lignes de bus classiques et dans les lignes complémentaires de bus, qui est égale à une constante lorsque, avantageusement les capacités C'_{bus} des lignes complémentaires de bus sont équivalentes aux capacités C_{bus} des lignes de bus qu'elles complètent.

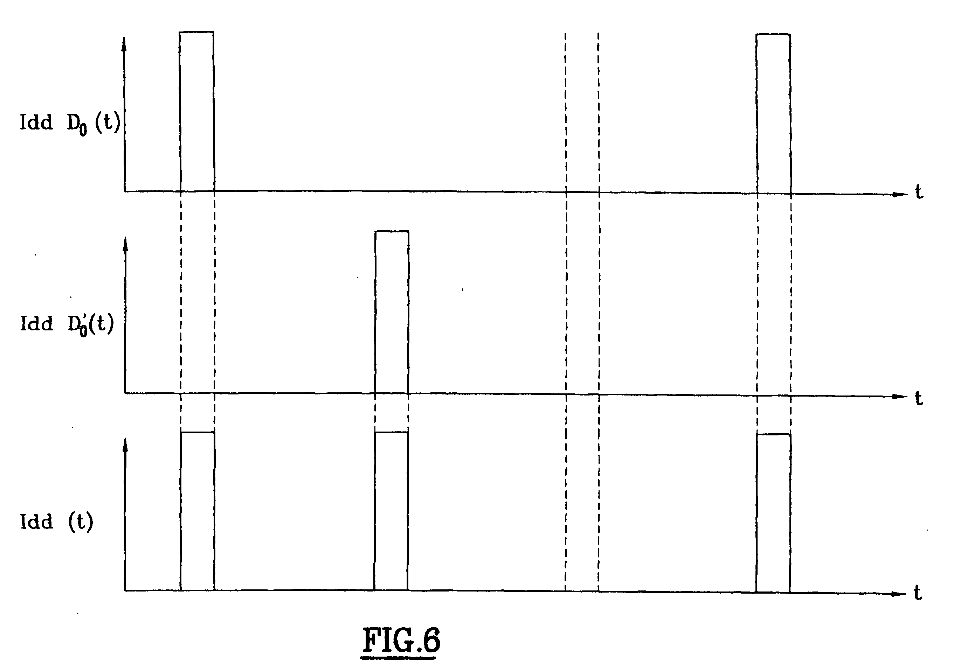

Par exemple, ainsi que cela est montré à la figure 6 relativement au cas d'une transmission de bits de données le long de la ligne D₀, Idd(t) = IddD₀(t) + IddD'₀(t) quels que soient les bits transmis le long de la ligne Do.

Bien entendu, le cadre large de l'invention s'étend à d'autres modes de réalisation dans lesquels, notamment, le dispositif à circuit intégré est pourvu de moyens complémentaires destinés à assurer une complète sécurité des informations confidentielles qu'il pourrait être amené à comporter.

## Revendications

1. Dispositif à circuit intégré destiné à être incorporé dans un objet portatif à mémoire, notamment au format carte, comportant au moins :
une unité centrale de traitement (CPU) ;
au moins une mémoire (RAM, ROM ou EEPROM) ;
au moins un plot d'entrée/sortie (I/O) de données ;
n lignes de bus d'adresses (A₀, A₁, ..., A₁₅) reliant l'unité centrale de traitement (CPU) à la mémoire (RAM, ROM ou EEPROM) et/ou au plot d'entrée/sortie (I/O) pour une transmission de bits d'adresses ; et
p lignes de bus de données (D₀, D₁, ..., D₇) reliant l'unité centrale (CPU) à la mémoire (RAM, ROM ou EEPROM) et/ou au plot d'entrée/sortie pour une transmission de bits de données,
**caractérisé en ce qu'**au moins une ligne de bus d'adresses ou de données est complétée d'une ligne complémentaire (A'₀, A'₁, ..., A'₁₅, D'₀, D'₁, ..., D'₇) destinée à une transmission de bits complémentaires aux bits transmis dans ladite ligne de bus d'adresses ou de données.

2. Dispositif selon la revendication 1, **caractérisé en ce que** la ligne complémentaire (A'₀, A'₁, ..., A'₁₅, D'₀, D'₁, ..., D'₇) a une capacité (C'_{bus}) équivalente à la capacité (C_{bus}) de la ligne de bus d'adresses (A₀, A₁, ..., A₁₅) ou de données (D₀, D₁, ..., D₇) qu'elle complète.

3. Dispositif selon l'une des revendications précédentes, **caractérisé en ce que** chacune des n lignes de bus d'adresses est complétée par une ligne complémentaire.

4. Dispositif selon l'une des revendications précédentes, **caractérisé en ce que** chacune des p lignes de bus de données est complétée par une ligne de bus complémentaire.

5. Dispositif selon l'une des revendications 3 ou 4, **caractérisé en ce que** les bits complémentaires forment des valeurs logiques, données ou adresses, complémentaires, aux valeurs logiques circulant par les bus.

6. Dispositif selon l'une des revendications précédentes, **caractérisé en ce que** pour chaque ligne, l'amplificateur est doublé.

## Claims

1. An integrated circuit device for incorporating in a portable article having a memory, in particular an article of card format, the device comprising at least:
· a central processor unit (CPU);
. at least one memory (RAM, ROM, EEPROM);
. at least one data input/output pad (I/O);
. n address bus lines (A₀, A₁, ... A₁₅) connecting the central processor unit (CPU) to the memory (RAM, ROM, EEPROM) and/or to the input/output (I/O) pad to carry address bits; and
. p data bus lines (D₀, D₁, ... D₇) connecting the central processor unit (CPU) to the memory (RAM, ROM, EEPROM) and/or to the input/output pad for conveying data bits;
wherein at least one address bus line or data bus line is associated with an additional line (A'₀, A'₁, ... A'₁₅, D'₀, D'₁,..., D'₇) for conveying bits that are complementary to the bits conveyed over said address bus line or data bus line.

2. A device according to claim 1, wherein the additional line (A'₀, A'₁, ... A'₁₅, D'₀, D'₁, ..., D'₇) has capacitance (C'_{bus}) equivalent to the capacitance (C_{bus}) of the address bus line (A₀, A₁, ... A₁₅) or the data bus line(D₀, D₁, ... D₇) with which it is associated.

3. A device according to claim 1, wherein each of the n address bus lines is associated with a respective additional line.

4. A device according to claim 1, wherein each of the p data bus lines is associated with a respective additional bus line.

5. A device according to claim 3 or 4, wherein the complementary bits form data or address logic values that are complementary to the logic values conveyed by the bus.

6. A device according one of the previous claim, wherein for each line, a dual amplifier is used.

## Patentansprüche

1. Vorrichtung mit integrierter Schaltung zum Einbau in ein tragbares Objekt mit Speicher, insbesondere im Kartenformat, welche mindestens folgende Elemente umfasst:
eine Zentraleinheit (CPU);
mindestens einen Speicher (RAM, ROM oder EEPROM);
mindestens eine Dateneingangs-/Ausgangsbuchse (I/O);
n Adressbusleitungen (A₀, A₁, ..., A₁₅), die die Zentraleinheit (CPU) zu einer Übertragung von Adressbits mit dem Speicher (RAM, ROM oder EEPROM) und/oder der Eingangs-/Ausgangsbuchse (I/O) verbinden; und
p Datenbusleitungen (D₀, D₁, ..., D₇), die die Zentraleinheit (CPU) zu einer Übertragung von Datenbits mit dem Speicher (RAM, ROM oder EEPROM) und/oder der Eingangs-/Ausgangsbuchse verbinden,
**dadurch gekennzeichnet, dass** mindestens eine Adress- oder Datenbusleitung von einer komplementären Leitung (A'₀, A'₁, ..., A'₁₅, D'₀, D'₁, ..., D'₇) ergänzt wird, die zur Übertragung von ergänzenden Bits zu den über besagte Adress- oder Datenbusleitung übertragenen bestimmt ist.

2. Vorrichtung nach Anspruch 1, **dadurch gekennzeichnet, dass** die komplementäre Leitung (A'₀, A'₁, ... , A'₁₅, D'₀, D'₁, ..., D'₇) eine der Kapazität (C_{bus}) der von ihr ergänzten Adressbusleitung (A₀, A₁, ..., A₁₅) oder Datenbusleitung (D₀, D₁, ..., D₇) entsprechende Kapazität (C'_{bus}) hat.

3. Vorrichtung nach einem der vorausgehenden Ansprüche, **dadurch gekennzeichnet, dass** jede der n Adressbusleitungen von einer komplementären Leitung ergänzt wird.

4. Vorrichtung nach einem der vorausgehenden Ansprüche, **dadurch gekennzeichnet, dass** jede der p Datenbusleitungen von einer komplementären Busleitung ergänzt wird.

5. Vorrichtung nach einem der Ansprüche 3 oder 4, **dadurch gekennzeichnet, dass** die komplementären Bits logische Werte - Daten oder Adressen - bilden, die zu den von den Bussen beförderten logischen Werten komplementär sind.

6. Vorrichtung nach einem der vorausgehenden Ansprüche, **dadurch gekennzeichnet, dass** der Verstärker bei jeder Leitung zweifach ist.
